# EUROPEAN PATENT APPLICATION

(11) **EP 1 309 001 A2**
(43) Date of publication of application: **07.05.2003**
(21) Application number: 02024449.7
(22) Date of filing: 29.10.2002
(51) Int. Cl.: H01L 23/28, H01L 23/31

(54) **Semiconductor device and manufacturing method thereof**

(30) Priority: 30.10.2001 JP 2001332600
(71) Applicant: Kabushiki Kaisha Tokai Rika Denki Seisakusho, Niwa-gun, Aichi 480-0195 (JP)
(72) Inventor: Tajima, Masaya, K.K. Tokai Rika Denki Seisakusho, Niwa-gun, Aichi 480-0195 (JP); Horibe, Masaru, K.K. Tokai Rika Denki Seisakusho, Niwa-gun, Aichi 480-0195 (JP)
(74) Representative: Reinhard - Skuhra - Weise & Partner GbR

(57) **Abstract**

A semiconductor device (11) has a package (13) for sealing a semiconductor chip (15) and a housing (12) for enveloping the package (13). The package (13) is formed with a thermoplastic resin and has fins (13a, 13b). The housing (12) is formed by insert molding a thermoplastic resin having a higher melting point than that of the resin forming the package (13). The semiconductor device (11) improves adherent between the package (13) and housing (12), thereby improving the moisture resistance.

## Description

### BACKGROUND OF THE INVENTION

The present invention relates to a semiconductor device and a method for manufacturing the device.

A typical semiconductor device has a plastic package for enveloping the housing to improve the moisture resistance. The housing is generally formed by insert molding a thermoplastic resin.

However, depending on the combination of the thermoplastic resin used for the package and the thermoplastic resin used for the housing, the package is not adhered to the housing, which creates a gap between the package and the housing. A gap between the package and the housing allows moisture to enter the interior. The moisture resistance of the device is there not satisfactory.

Since the package and the housing are required to have a high heat resistance, the types of resin that can be used for the package and the housing are limited. It is therefore desired that the adherent between the package and the housing be improved without depending on the types of the resins for the package and the housing.

### SUMMARY OF THE INVENTION

Accordingly, it is an objective of the present invention to provide a semiconductor device and a method for manufacturing the device that improves the adherence between the package and the housing, and reliably improves the moisture resistance.

To achieve the foregoing and other objectives and in accordance with the purpose of the present invention, a semiconductor device is provided. The device has a package for sealing a semiconductor chip and a housing for enveloping the package. The package is formed with a first thermoplastic resin and has a fin. The housing is formed with a second thermoplastic resin through insert molding. The melting point of the second thermoplastic resin is higher than the melting point of the first thermoplastic resin.

A further perspective of the present invention is a method for manufacturing a semiconductor device. A package is molded with a first thermoplastic resin to seal a semiconductor chip. The molded package has a fin. A housing is insert molded with a second thermoplastic resin to envelop the package. The melting point of the second thermoplastic resin is higher than the melting point of the first thermoplastic resin. The housing is insert molded by filling a mold in which the package is placed with the molten second thermoplastic resin. The heat of the filling second thermoplastic resin melts the fin of the package.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a perspective view illustrating a semiconductor device according to one embodiment of the present invention;
Fig. 2 is a plan view illustrating a lead frame;
Fig. 3 is a perspective view illustrating the lower half of a mold used for molding a package, when the lead frame of Fig. 2 is placed on the half;
Fig. 4 is a cross-sectional view illustrating a mold in a process of insert molding a package;
Fig. 5(a) is plan view showing the lead frame of Fig. 2 on which a package is formed;
Fig. 5(b) is a cross-sectional view taken along line 5b-5b of Fig. 5(a); and
Fig. 6 is a cross-sectional view illustrating a mold in a process of insert molding a housing.

### DETAILED DESCRIPTION OF THE PREFERRED EMBODIMENTS

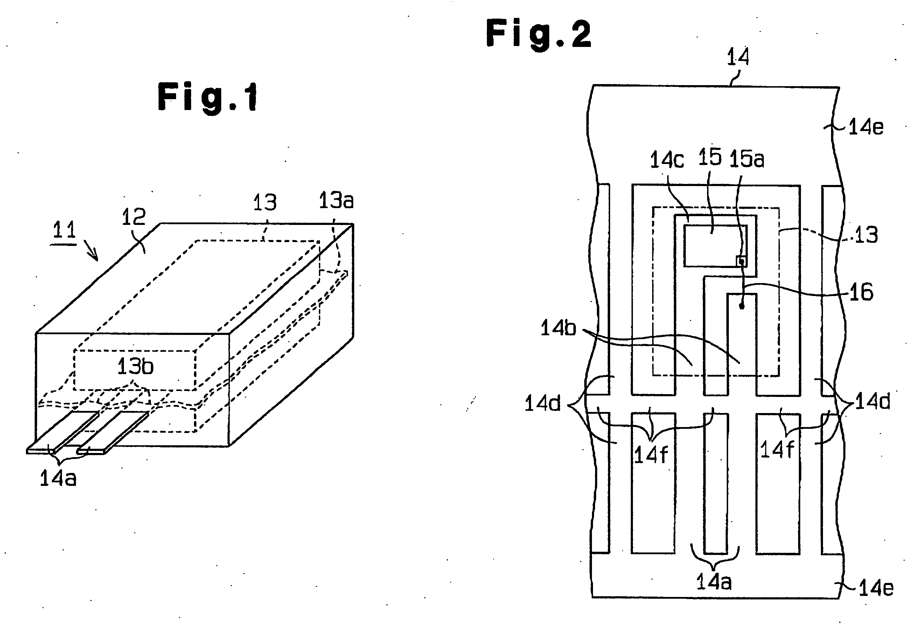

One embodiment according to the present invention will now be described with reference to Figs. 1 to 6.

As shown in Fig. 1, a semiconductor device 11 includes a rectangular parallelepiped package 13 made of liquid crystal polymer (LCP). A pair of plate-like lead terminals 14a extend from one of the four sides of the package 13. The entire package 13 is enveloped with a substantially rectangular parallelepiped housing 12 made of polyphenylene sulfide (PPS). The lead terminals 14a extend from one of the four sides of the housing 12.

The package 13 has a first fin 13a and two second fins 13b. The first and second fins 13a, 13b surround the entire circumference of the package 13. The first fin 13a extends along the four sides of the package 13 and is located in the same plane as the lead terminals 14a. The thickness of the first fin 13a is substantially the same as that of the lead terminals 14a. In this embodiment, the thickness of the first fin 13a is 0.25 mm to 0.4 mm. The second fins 13b coat the proximal portions of the lead terminals 14a. In this embodiment, the thickness of the second fins 13b is approximately 0.2 mm.

Fig. 2 illustrates a lead frame 14 used for manufacturing the package 13. As shown in Fig. 2, the lead frame 14 includes the parallel lead terminals 14a. An inner lead portion 14b extends from the proximal end (upper end as viewed in Fig. 2) of each lead terminal 14a. Specifically, a first inner lead portion 14b extends from the first lead terminal 14a (left lead terminal 14a as viewed in Fig. 2). The first inner lead portion 14b has a substantially rectangular island 14c. A substantially rectangular semiconductor chip 15 is mounted on the island 14c. An electrode pad 15a is located on the semiconductor chip 15. A second inner lead portion 14b, which extends from the second lead terminal 14a (right lead terminal 14a as viewed in Fig. 2), is electrically connected to the electrode pad 15a with a wire 16. A pair of frame portions 14d are located parallel to and outward of the lead terminals 14a. A pair of carrier portions 14e are connected to the ends of the frame portions 14d. The distal end of each lead terminal 14a (lower end as viewed in Fig. 2) is connected to one of the carrier portions 14e. The lead terminals 14a are connected with a tie bar 14f. Also, each lead terminal 14a and the adjacent frame portion 14d are connected with a tie bar 14f.

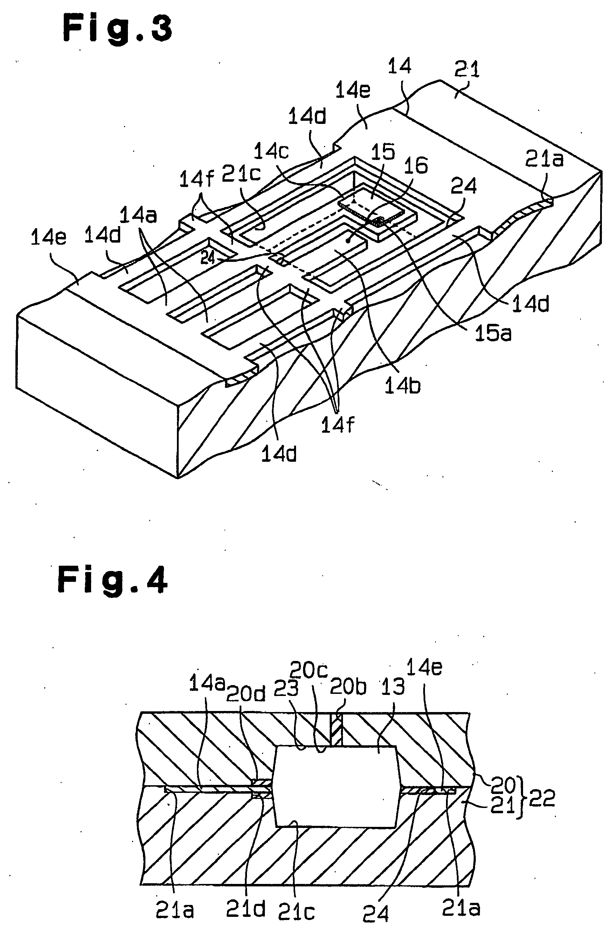

Fig. 4 illustrates a mold 22 used for molding the package 13. As shown in Fig. 4, the mold 22 has an upper half 20 and a lower half 21. A recess 20c is formed in the upper half 20. A recess 21c is formed in the lower half 21. The recesses 20c, 21c define a cavity 23 for forming the package 13. Grooves 20d for forming the second fins 13b are formed in the upper half 20. Also, a gate 20b communicated with the recess 20c is formed in the upper half 20. Except for the recess 20c and the grooves 20d, the lower face of the upper half 20 is formed flat. A frame recess 21a is formed in the lower half 21. The frame recess 21a corresponds to the outline of the lead frame 14. Grooves 21d for forming the second fins 13b are also formed in the lower half 21. Except for the recess 21c, the frame recess 21a, and the grooves 21d, the upper face of the lower half 21 is formed flat.

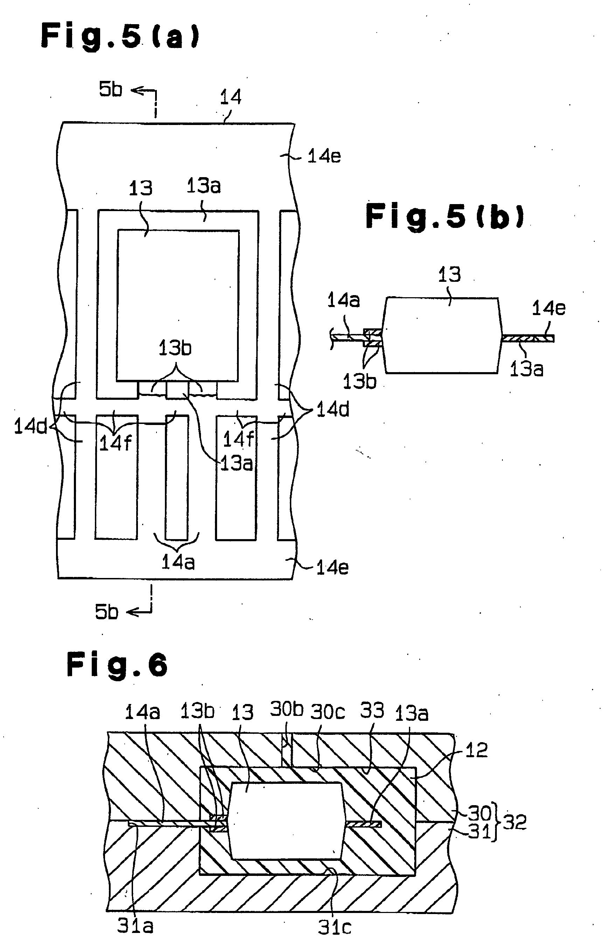

Fig. 6 illustrates a mold 32 used for molding the housing 12. As shown in Fig. 4, the mold 32 has an upper half 30 and a lower half 31. A recess 30c is formed in the upper half 30. A recess 31c is formed in the lower half 31. The recesses 30c, 31c define a cavity 33 for forming the housing 12. The cavity 33 is sufficiently large to accommodate the package 13, the first fin 13a, and the second fins 13b. A gate 30b communicated with the recess 30c is formed in the upper half 30. Except for the recess 30c, the lower face of the upper half 30 is formed flat. Terminal recesses 31a are formed in the lower half 31. The terminal recesses 31a correspond to the outlines of the lead terminals 14a. Except for the recess 31c and the terminal recesses 31a, the upper face of the lower half 31 is formed flat.

When manufacturing the semiconductor device 11, a metal plate is pressed to form the lead frame 14. Then, the semiconductor chip 15 is placed on the island 14c of the lead frame 14. The electrode pad 15a of the semiconductor chip 15 is electrically connected with the second inner lead portion 14b with the wire 16.

Subsequently, the package 13 is formed through insert molding to seal the semiconductor chip 15. Specifically, the lead frame 14 is placed in the frame recess 21a of the lower half 21 (see Fig. 3). Thereafter, the upper half 20 and the lower half 21 are put together. This creates a gap 24 between the cavity 23 and the frame portions 14d, between the cavity and one of the carrier portions 14e, and between the cavity 23 and the tie bar 14f (see Figs. 3 and 4). The gap 24 is a space for forming the first fin 13a. In this state, molten liquid crystal polymer is injected through the gate 20b to fill the cavity 23, the grooves 20d, 21d, and the gap 24. The mold 22 is opened after the liquid crystal polymer is hardened to obtain the lead frame 14 with the package 13 (see Figs. 5(a) and 5(b)). The melting point of the liquid crystal polymer used in this embodiment is 290'C.

Then, unnecessary parts of the lead frame 14, or the frame portions 14d, the carrier portions 14e and the tie bars 14f are removed by cutting. In this manner, the package 13 with a pair of the lead terminals 14a extending from a side is formed. The housing 12 is then formed through insert molding by using the package 13. Specifically, the package 13 is placed in the lower half 31 such that the lead terminals 14a fit in the terminal recesses 31a. Thereafter, the upper half 30 and the lower half 31 are put together. Then, molten polyphenylene sulfide is injected through the gate 30b to fill the cavity 33 (see Fig. 6). The mold 32 is opened after the polyphenylene sulfide is hardened to obtain the housing 12 enveloping the package 13 (see Fig. 1). The melting point of the polyphenylene sulfide used in this embodiment is 340°C.

This embodiment provides the following advantages.

The melting point of the liquid crystal polymer forming the package 13 is lower than the melting point of the polyphenylene sulfide forming the housing 12. Therefore, the heat of the molten polyphenylene sulfide injected into the mold 32 for molding the housing 12 melts the surface of the package 13, particularly the first and second fins 13a, 13b. As a result, the package 13 is welded to the housing 12 by the heat. This improves the adherent between the package 13 and the housing 12 is improved, and therefore prevents gap from being created between the package 13 and the housing 12. Accordingly, the moisture resistance of the semiconductor device 11 is improved.

The second fins 13b coats the proximal portions of the lead terminals 14a. The second fins 13b are melted when the housing 12 is molded and seals the joints between the proximal portions of the lead terminals 14a and package 13. This improves the moisture resistance of the semiconductor device 11. The second fins 13b also prevent the lead terminals 14a from establishing a short circuit.

The housing 12 is formed with polyphenylene sulfide having a high heat resistance. Therefore, compared to a semiconductor without the housing 12, the semiconductor device 11 of this embodiment has an improved heat resistance.

The lead frame 14 has tie bars 14f. The tie bars 14f prevent the fin 13a from interfering with the lead terminals 14a.

It should be apparent to those skilled in the art that the present invention may be embodied in many other specific forms without departing from the spirit or scope of the invention. Particularly, it should be understood that the invention may be embodied in the following forms.

Any thermoplastic resin may be used for forming the package 13 as long as the melting point of the resin is lower than the thermoplastic resin used for forming the housing 12. For example, a polyphenylene sulfide having a lower melting point than that of the polyphenylene sulfide forming the housing 12 may be used.

Any thermoplastic resin may be used for forming the housing 12 as long as the melting point of the resin is higher than the thermoplastic resin used for forming the package 13. For example, polyamide (PA) may be used.

The width and the thickness of the first fin 13a may be changed as necessary.

The width and the thickness of the second fins 13b may be changed as necessary.

The number of the lead terminals 14a is not limited to two, but may be one or more than two.

The lead terminals 14a may protrude from two or more sides of the housing 12.

The circumference of the package 13 need not be entirely surrounded by the first and second fins 13a, 13b.

The first fin 13a need not be located in the same plane as the lead terminals 14a.

The shapes of the housing 12 and the package 13 are not limited to rectangular parallelepipeds, but may be changed as necessary.

Therefore, the present examples and embodiments are to be considered as illustrative and not restrictive and the invention is not to be limited to the details given herein, but may be modified within the scope and equivalence of the appended claims.

## Claims

1. A semiconductor device comprising a package (13) for sealing a semiconductor chip (15) and a housing (12) for enveloping the package (13), the device being **characterized in that**:
the package (13) is formed with a first thermoplastic resin and has a fin (13a, 13b), wherein the housing (12) is formed with a second thermoplastic resin through insert molding, and wherein the melting point of the second thermoplastic resin is higher than the melting point of the first thermoplastic resin.

2. The device according to claim 1, **characterized in that** the fin (13a) is located in the same plane as a lead terminal (14a) extending from the package (13).

3. The device according to claim 1 or 2, **characterized in that** the fin (13b) coats the proximal portion of a lead terminal (14a) extending from the package (13).

4. The device according to any one of claims 1 to 3, **characterized in that** the first thermoplastic resin is liquid crystal polymer.

5. The device according to any one of claim 1 to 4, **characterized in that** the second thermoplastic resin is polyphenylene sulfide.

6. The device according to any one of claim 1 to 5, **characterized in that** the fin (13a, 13b) surrounds the entire circumference of the package (13).

7. A method for manufacturing a semiconductor device, **characterized by**:
molding a package (13) with a first thermoplastic resin to seal a semiconductor chip (15), wherein the molded package (13) has a fin (13a, 13b); and
insert molding a housing (12) with a second thermoplastic resin to envelop the package (13), wherein the melting point of the second thermoplastic resin is higher than the melting point of the first thermoplastic resin, wherein the housing (12) is insert molded by filling a mold (32) in which the package (13) is placed with the molten second thermoplastic resin, and wherein the heat of the filling second thermoplastic resin melts the fin (13a, 13b) of the package (13).

8. The method according to claim 7, **characterized in that** the fin (13a) is located in the same plane as a lead terminal (14a) extending from the package (13).

9. The method according to claim 7 or 8, **characterized in that** the fin (13b) coats the proximal portion of a lead terminal (14a) extending from the package (13).

10. The method according to any one of claims 7 to 9, **characterized in that** the first thermoplastic resin is liquid crystal polymer.

11. The method according to any one of claims 7 to 10, **characterized in that** the second thermoplastic resin is polyphenylene sulfide.

12. The method according to any one of claims 7 to 11, **characterized in that** the fin (13a, 13b) surrounds the entire circumference of the package (13).
